# FASCICULE DE BREVET EUROPEEN

(11) **EP 3 072 372 B1**
(45) Date de publication et mention de la délivrance du brevet: **06.01.2021**
(21) Numéro de dépôt: 14802051.4
(22) Date de dépôt: 21.11.2014
(51) Int. Cl.: H05K 1/02, H02M 3/335, H05K 1/16, H01F 27/00, H02M 3/28, H01F 27/28

(54) **CARTE ÉLECTRONIQUE COMPRENANT DES ÉLÉMENTS MAGNÉTIQUES**
ELEKTRONISCHE KARTE MIT MAGNETISCHEN ELEMENTEN
ELECTRONIC CARD WITH MAGNETIC ELEMENTS

(30) Priorité: 22.11.2013 FR 1302696
(43) Date de publication de la demande: 28.09.2016
(73) Titulaire: THALES, 92400 Courbevoie (FR)
(72) Inventeur: GUEPRATTE, Kevin, 78851 Elancourt Cedex (FR); STEPHAN, Hervé, 78851 Elancourt Cedex (FR)
(74) Mandataire: Marks & Clerk France
(86) Numéro de dépôt international: PCT/EP2014/075249
(87) Numéro de publication internationale: WO 2015/075172

(56) Documents cités:
- EP-A1- 1 962 302
- EP-A2- 1 037 221
- DE-U1- 29 715 106
- DE-U1- 29 715 106

## Description

L'invention porte sur une carte électronique comprenant au moins deux éléments magnétiques. L'invention concerne principalement le domaine de l'électronique de puissance, et plus particulièrement celui des circuits électroniques de puissance embarqués, notamment pour des applications aéronautiques.

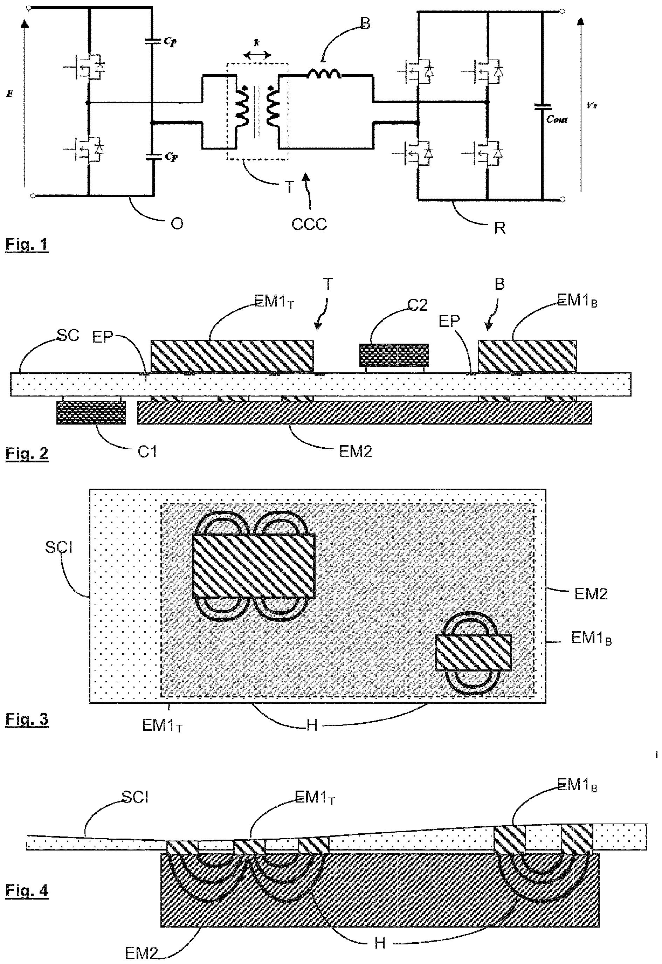

Les circuits électroniques de puissance, tels que les convertisseurs de tension continu/continu ou alternatif/continu, comprennent généralement des composants magnétiques - bobines et condensateurs. A titre d'exemple, la figure 1 représente le schéma électrique d'un convertisseur continu/continu CCC comprenant un onduleur en demi-pont O, un redresseur actif en pont complet R, un transformateur T dont l'enroulement primaire est relié à l'onduleur O et l'enroulement secondaire est relié au redresseur R, et une bobine B connectée en série audit enroulement secondaire mais découplée magnétiquement dudit transformateur. Ces composants magnétiques (T, B) - et plus particulièrement leurs noyaux magnétiques (en fait, ferromagnétiques) - contribuent de manière très significative à l'encombrement du circuit. Or, l'encombrement constitue une contrainte majeure, notamment dans les applications embarquées - et plus particulièrement aéronautiques - où l'espace disponible est très limité.

Il est connu de réaliser des circuits électroniques de puissance sous la forme de cartes électroniques comprenant un substrat planaire de circuit imprimé portant des composants électriques et électroniques à montage en surface. Dans ces cartes électroniques, les composants magnétiques sont réalisés en technologie planaire : les enroulements sont formés par des pistes déposées sur une ou deux faces du substrat de circuit imprimé et chaque noyau magnétique est constitué par un premier élément « en E » (avec trois jambes) ou « en U » (avec deux jambes), et par un second élément « en I » (sans jambes, en forme de plaque ou barrette) fermant le circuit magnétique. Les premiers éléments sont agencés sur une première face, dite face avant, du substrat ; les seconds éléments sont agencés sur une seconde face, dite face arrière, du substrat ; et les jambes traversent le substrat grâces à des ouvertures pratiquées dans ce dernier. EP 1 962 302 A1, EP 1 037 221 A2 et DE 297 15 106 U1 divulguent, par exemple, le préambule de la revendication 1. Cette technique permet de limiter l'encombrement des composants magnétiques ; toutefois, l'épaisseur des noyaux reste relativement importante. En effet, la théorie des circuits magnétiques montre que le flux magnétique à l'intérieur d'un noyau est inversement proportionnel à sa reluctance, qui est à son tour inversement proportionnelle à sa section, et donc à son épaisseur. La nécessité d'assurer un flux magnétique déterminé, pour une force magnétomotrice donnée, impose donc une épaisseur minimale des éléments formant les noyaux magnétiques.

L'invention vise à surmonter cet inconvénient de l'art antérieur et à procurer des cartes de circuits intégrés comprenant des éléments magnétiques qui présentent un encombrement réduit, et plus particulièrement une faible épaisseur.

Un objet de l'invention, permettant d'atteindre ce but, est une carte électronique comprenant : un substrat planaire présentant une première face et une seconde face opposée à ladite première face ; au moins deux éléments de noyaux magnétiques, dits premiers éléments, agencés sur ladite première face dudit substrat et présentant chacun au moins deux jambes traversant ledit substrat ; et au moins deux enroulements, agencés autour d'au moins une jambe de chaque dit premier noyau magnétique ; caractérisée en ce que : elle comprend également un second élément de noyau magnétique en forme de plaque, agencé sur ladite deuxième face dudit substrat et en contact avec des extrémités respectives desdites jambes desdits ou d'au moins deux dits premiers éléments ; et en ce que : l'espacement entre lesdits premiers éléments est suffisant pour empêcher tout couplage magnétique entre eux par l'intermédiaire dudit second élément ; moyennant quoi lesdits premiers éléments, lesdits enroulements et ledit second élément forment au moins deux circuits magnétiques non couplés entre eux.

Selon des modes de réalisation particuliers de l'invention :
- Ledit substrat planaire peut être un substrat de circuit imprimé.
- Lesdits enroulements peuvent être des enroulements planaires, formés par des pistes conductrices déposées sur ledit substrat planaire.
- Ladite carte électronique peut comprendre un circuit électronique de puissance réalisé sur ledit substrat et incluant lesdits circuits magnétiques non couplés entre eux. En particulier, ledit circuit électronique de puissance peut être un convertisseur continu/continu ou alternatif/continu. Au moins un dit premier élément de noyau magnétique peut être un élément de type « en E » formant, avec deux dits enroulements et ledit second élément de noyau magnétique, un transformateur, et au moins un autre dit premier élément de noyau magnétique est un noyau de type « en U » formant, avec un dit enroulement et ledit second élément de noyau magnétique, une bobine. Dans ce cas, ladite bobine peut être connectée en série à un enroulement dudit transformateur.
- Ladite seconde face dudit substrat peut porter au moins un composant électrique ou électronique, la hauteur dudit second élément de noyau magnétique par rapport à ladite seconde face étant inférieure ou égale à celle dudit composant, ou du composant présentant la plus grande hauteur.
- Ledit circuit électronique de puissance peut être réalisé en technologie à montage en surface.
- Ledit second élément de noyau magnétique peut présenter une perméabilité magnétique supérieure d'au moins un facteur 10, et de préférence d'au moins un facteur 100, à celle desdits premiers éléments de noyaux magnétiques.

D'autres caractéristiques, détails et avantages de l'invention ressortiront à la lecture de la description faite en référence aux dessins annexés donnés à titre d'exemple et qui représentent, respectivement :
- la figure 2, une vue du côté d'une carte électronique selon un mode de réalisation de l'invention ;
- la figure 3, une vue en plan, par transparence, de la carte électronique de la figure 2, mettant en évidence les lignes du champ magnétique à l'intérieur du second élément de noyau magnétique ; et
- la figure 4, une vue de détail, en coupe, de la carte électronique de la figure 2, mettant en évidence les lignes du champ magnétique à l'intérieur du second élément de noyau magnétique.

Une idée à la base de la présente invention consiste à utiliser, sur la face arrière du substrat de circuit imprimé, un élément de noyau magnétique « en I » en forme de plaque, commun à plusieurs circuits magnétiques distincts et découplés entre eux, et donc à plusieurs premiers éléments de noyaux agencés sur la face avant dudit substrat. Cela permet aux lignes du champ magnétique de se répartir sur une plus grande surface, réduisant la réluctance du circuit magnétique pour une épaisseur donnée de l'élément de noyau en forme de plaque. A son tour, cela permet de réduire cette épaisseur, et donc l'épaisseur de la carte électronique, pour une valeur de réluctance donnée. Par ailleurs, la présence d'une plaque métallique sur la face arrière du substrat de circuit imprimé facilite la dissipation de la chaleur. En outre, les opérations d'assemblage sont simplifiées, car il y a moins d'éléments magnétiques distincts à positionner.

La figure 2 (qui n'est pas à l'échelle) illustre, de manière très schématique, une carte électronique mettant en œuvre l'invention. Cette carte est constituée par un substrat de circuit imprimé double-face, SCI, portant une pluralité de composants électriques, électroniques et magnétiques interconnectés pour réaliser le circuit de la figure 1. Dans un souci de simplification, seuls sont représentés deux circuits intégrés à montage en surface, C1 (monté sur la face arrière du substrat SCI) et C2 (monté sur la face avant), un transformateur T et une bobine B, réalisés en technologie planaire.

Le transformateur T comprend un premier élément de noyau magnétique EM1_{T}, par exemple en ferrite, de type « en E », c'est-à-dire présentant trois jambes. L'élément EM1_{T} est agencé sur la face avant du substrat SCI, avec ses jambes traversant ledit substrat pour émerger du côté de la face arrière. Les enroulements primaires et secondaires sont planaires, c'est-à-dire constitués par des pistes déposées sur au moins une face du substrat (ici, la face avant) ; ils sont identifiés par la référence EP.

La bobine B comprend un premier élément de noyau magnétique EM1_{B}, par exemple en ferrite, de type « en U », c'est-à-dire présentant deux jambes. L'élément EM1_{B} est également agencé sur la face avant du substrat SCI, avec ses jambes traversant ledit substrat pour émerger du côté de la face arrière. Un seul enroulement planaire EP est prévu, autour de l'une des deux jambes.

La fermeture des deux circuits magnétiques est assurée par un élément de noyau magnétique commun, EM2, formant une plaque portée par la face arrière du substrat SCI, en contact avec les extrémités des jambes des premiers éléments EM1_{T} et EM1_{B}.

Les figures 3 et 4 (qui ne sont pas à l'échelle et qui, dans un souci de simplicité, ne montrent pas les composants C1 et C2) permettent de visualiser les lignes du champ magnétique H à l'intérieur du noyau magnétique commun EM2 lorsque les enroulements EP sont alimentés en courant. La figure 3, en particulier, montre que les lignes du champ magnétique s'étendent latéralement au-delà des empreintes des premiers éléments de noyau EM1_{T} et EM1_{B}, mais pas assez pour enduire un couplage magnétique significatif entre la bobine et le transformateur. Cela signifie que l'élément de noyau commun se comporte comme une paire d'éléments de noyaux séparés, présentant une « largeur effective » supérieure à celle des premiers éléments EM1_{T} et EM1_{B}. Comme cela a été mentionné plus haut, cela permet de réduire son épaisseur, par rapport à un cas conventionnel où le second élément de noyau de chaque circuit magnétique a une empreinte égale à celle du premier élément de noyau correspondant, sans augmenter sa réluctance. Avantageusement, cette épaisseur sera au plus égale à celle du composant électronique monté sur la face arrière et présentant la plus grande hauteur par rapport à ladite face (C1, dans l'exemple de la figure 2).

En phase de conception, il faudra veiller à ce que les premiers éléments de noyaux soient suffisamment éloignés entre eux pour que, effectivement, il n'y ait pas de couplage magnétique entre les différents circuits magnétiques. Cela peut être assuré au moyen de simulations numériques. A titre indicatif, on peut considérer que le couplage magnétique entre deux circuits magnétiques est négligeable si l'inductance mutuelle entre deux enroulements de deux circuits différents est inférieure d'au moins un facteur 100, voire d'un facteur 1000, à l'auto-inductance de chacun de ces enroulements.

Pour réduire les couplages magnétiques parasites qui pourraient éventuellement subsister, il est possible d'utiliser un second élément de noyau EM2 présentant une perméabilité magnétique supérieure d'un facteur 100, voire d'un facteur 1000, à celle des premiers éléments EM1_{T}, EM1_{B}. Cela a pour effet de « resserrer » les lignes du champ magnétique.

L'invention a été décrite en référence à un mode de réalisation particulier, donné à titre d'exemple non limitatif, mais elle admet de nombreuses variantes. En particulier :
- La carte électronique peut réaliser un circuit électronique autre que le convertisseur représenté sur la figure 1, voire une pluralité de circuits distincts.
- Les circuits magnétiques partageant un même second élément de noyau peuvent être plus de deux, et présenter plus de deux ou trois jambes.
- Une même carte électronique peut présenter une pluralité de seconds éléments de noyau, associés chacun à une pluralité de premiers éléments respectifs.
- L'identification d'une face du substrat en tant que « face avant » ou « face arrière » est arbitraire. Les pistes conductrices et les composants électriques ou électroniques peuvent être agencés sur l'une seule des deux faces, ou sur les deux.
- Il n'est pas essentiel que le substrat soit un substrat de circuit imprimé, que le ou les circuits électroniques soient réalisés en technologie à montage en surface et/ou que les enroulements soient de type planaire.
- Tout matériau ferromagnétique peut convenir à la réalisation des éléments de noyaux.

## Revendications

1. Carte électronique comprenant :
- un substrat planaire (SCI) présentant une première face et une seconde face opposée à ladite première face ;
- au moins deux éléments de noyaux magnétiques (EM1_{T}, EM1_{B}), dits premiers éléments, agencés sur ladite première face dudit substrat et présentant chacun au moins deux jambes traversant ledit substrat ; et
- au moins deux enroulements (EP), agencés autour d'au moins une jambe de chaque dit premier noyau magnétique ;
**caractérisée en ce que** :
- elle comprend également un second élément de noyau magnétique (EM2) en forme de plaque, agencé sur ladite deuxième face dudit substrat et en contact avec des extrémités respectives desdites jambes desdits ou d'au moins deux dits premiers éléments ;
et **en ce que** :
- l'espacement entre lesdits premiers éléments est suffisant pour empêcher tout couplage magnétique entre eux par l'intermédiaire dudit second élément ;
moyennant quoi lesdits premiers éléments, lesdits enroulements et ledit second élément forment au moins deux circuits magnétiques non couplés entre eux.

2. Carte électronique selon la revendication 1, dans laquelle ledit substrat planaire est un substrat de circuit imprimé.

3. Carte électronique selon la revendication 2, dans lequel lesdits enroulements sont des enroulements planaires, formés par des pistes conductrices déposées sur ledit substrat planaire.

4. Carte électronique selon l'une des revendications précédentes, comprenant un circuit électronique de puissance (CCC) réalisé sur ledit substrat et incluant lesdits circuits magnétiques non couplés entre eux.

5. Carte électronique selon la revendication 4, dans lequel ledit circuit électronique de puissance est un convertisseur continu/continu ou alternatif/continu.

6. Carte électronique selon l'une des revendications 4 ou 5, dans lequel au moins un dit premier élément de noyau magnétique est un élément de type « en E » (EM1_{T}) formant, avec deux dits enroulements et ledit second élément de noyau magnétique, un transformateur (T), et au moins un autre dit premier élément de noyau magnétique est un noyau de type « en U » (EM1_{B}) formant, avec un dit enroulement et ledit second élément de noyau magnétique, une bobine (B).

7. Carte électronique selon la revendication 6, dans laquelle ladite bobine est connectée en série à un enroulement dudit transformateur.

8. Carte électronique selon l'une des revendications 4 à 7 dans laquelle ladite seconde face dudit substrat porte au moins un composant électrique ou électronique, la hauteur dudit second élément de noyau magnétique par rapport à ladite seconde face étant inférieure ou égale à celle dudit composant, ou du composant présentant la plus grande hauteur.

9. Carte électronique selon l'une des revendications 4 à 8 dans laquelle ledit circuit électronique de puissance est réalisé en technologie à montage en surface.

10. Carte électronique selon l'une des revendications précédentes, dans lequel ledit second élément de noyau magnétique présente une perméabilité magnétique supérieure d'au moins un facteur 10, et de préférence d'au moins un facteur 100, à celle desdits premiers éléments de noyaux magnétiques.

## Patentansprüche

1. Elektronische Karte, Folgendes umfassend:
- ein planares Substrat (SCI), welches eine erste Seite und eine zweite Seite gegenüber der ersten Seite aufweist;
- mindestens zwei Magnetkernelemente (EM1_{T}, EM1_{B}), genannt erste Elemente, welche auf der ersten Seite des Substrates angeordnet sind und jeweils mindestens zwei Beine aufweisen, welche das Substrat durchqueren; und
- mindestens zwei Wicklungen (EP), welche um mindestens ein Bein eines jeden ersten Magnetkerns angeordnet sind;
**dadurch gekennzeichnet, dass**:
- sie ferner ein zweites Magnetkernelement (EM2) in Form einer Platte umfasst, welches auf der zweiten Seite des Substrates angeordnet ist und in Kontakt mit jeweiligen Enden der Beine der oder mindestens zwei solcher ersten Elemente steht;
und dadurch, dass:
- der Abstand zwischen den ersten Elementen ausreicht, um jegliche magnetische Kopplung dazwischen über das zweite Element zu verhindern;
wodurch die ersten Elemente, die Wicklungen und das zweite Element mindestens zwei Magnetkreise bilden, welche nicht miteinander gekoppelt sind.

2. Elektronische Karte nach Anspruch 1, wobei das planare Substrat ein Leiterplattensubstrat ist.

3. Elektronische Karte nach Anspruch 2, wobei die Wicklungen planare Wicklungen sind, welche aus auf dem planaren Substrat abgelagerten leitfähigen Spuren gebildet sind.

4. Elektronische Karte nach einem der vorhergehenden Ansprüche, welche einen auf dem Substrat hergestellten elektronischen Leistungsschaltkreis (CCC) umfasst und welche nicht miteinander gekoppelte Magnetkreise einschließt.

5. Elektronische Karte nach Anspruch 4, wobei der elektronische Leistungsschaltkreis ein Gleichstrom-/Gleichstromwandler oder ein Wechselstrom-/Gleichstromwandler ist.

6. Elektronische Karte nach einem der Ansprüche 4 oder 5, wobei mindestens ein solches erstes Magnetkernelement ein "E-förmiges" (EM1_{T}) Element ist, welches mit zwei solchen Wicklungen und dem zweiten Magnetkernelement einen Transformator (T) bildet, und mindestens ein anderes solches erstes Magnetkernelement ein "U-förmiges" (EM1_{B}) Element ist, welches mit einer solchen Wicklung und dem zweiten Magnetkernelement eine Spule (B) bildet.

7. Elektronische Karte nach Anspruch 6, wobei die Spule in Reihe mit einer Wicklung des Transformators verbunden ist.

8. Elektronische Karte nach einem der Ansprüche 4 bis 7, wobei die zweite Seite des Substrats mindestens ein elektrisches oder elektronisches Bauteil trägt, wobei die Höhe des zweiten Magnetkernelements in Bezug auf die zweite Seite kleiner als die oder gleich derjenigen des Bauteils, bzw. desjenigen Bauteils, welches die größte Höhe aufweist, ist.

9. Elektronische Karte nach einem der Ansprüche 4 bis 8, wobei der elektronische Leistungsschaltkreis anhand von Oberflächenmontagetechnologie hergestellt ist.

10. Elektronische Karte nach einem der vorhergehenden Ansprüche, wobei das zweite Magnetkernelement eine magnetische Permeabilität aufweist, welche um mindestens einen Faktor 10 und vorzugsweise um mindestens einen Faktor 100 höher als diejenige der ersten Magnetkernelemente ist.

## Claims

1. An electronic board comprising:
- a planar substrate (SCI) having a first side and a second side, opposite said first side;
- at least two magnetic core elements (EM1_{T}, EM1_{B}), called first elements, arranged on said first side of said substrate and each having at least two legs passing through said substrate; and
- at least two windings (EP), arranged around at least one leg of each said first magnetic core;
**characterized in that**:
- it also comprises a second magnetic core element (EM2) in the form of a plate, arranged on said second side of said substrate and in contact with respective ends of said legs of said or of at least two said first elements;
and **in that**:
- the spacing between said first elements is sufficient to prevent any mutual magnetic coupling via said second element;
whereby said first elements, said windings and said second element form at least two magnetic circuits that are not mutually coupled.

2. The electronic board according to claim 1, wherein said planar substrate is a printed circuit board substrate.

3. The electronic board according to claim 2, in which said windings are planar windings, formed by conductive tracks deposed on said planar substrate.

4. The electronic board according to one of the preceding claims, comprising a power electronics circuit (CCC) implemented on said substrate and that includes said magnetic circuits that are not mutually coupled.

5. The electronic board according to claim 4, wherein said power electronics circuit is a DC/DC or AC/DC converter.

6. The electronic board according to either of claims 4 or 5, wherein at least one said first magnetic core element is an "E-shaped" type element (EM1_{T}) forming, with two said windings and said second magnetic core element, a transformer (T), and at least one other said first magnetic core element is a "U-shaped" type element (EM1_{B}) forming, with one said winding and said second magnetic core element, a coil (B).

7. The electronic board according to claim 6, wherein said coil is connected in series with a winding of said transformer.

8. The electronic board according to one of claims 4 to 7, wherein said second side of said substrate bears at least one electric or electronic component, the height of said second magnetic core element, with respect to said second side, being less than or equal to that of said component, or of the component having the greatest height.

9. The electronic board according to one of claims 4 to 8, wherein said power electronics circuit is implemented using surface-mount technology.

10. The electronic board according to one of the preceding claims, wherein said second magnetic core element has a magnetic permeability that is greater by at least a factor 10, and preferably by at least a factor 100, than that of said first magnetic core elements.
